Europäisches Patentamt

European Patent Office

Office européen des brevets

(11) Veröffentlichungsnummer: **0 175 176**
**A2**

## (12) EUROPÄISCHE PATENTANMELDUNG

(21) Anmeldenummer: **85110720.1**

(22) Anmeldetag: **26.08.85**

(51) Int. Cl.⁴: **H 01 H 13/70,** H 03 K 17/96, G 06 K 11/06, H 03 M 11/00

(30) Priorität: **15.09.84 DE 3433921**

(43) Veröffentlichungstag der Anmeldung: **26.03.86**
**Patentblatt 86/13**

(84) Benannte Vertragsstaaten: **FR GB IT SE**

(71) Anmelder: **CARL SCHNEIDER GmbH & Co. K.G.,**
**D-6105 Ober-Ramstadt/Rohrbach (DE)**

(72) Erfinder: **Weinert, Werner, Dr.-Ing., Eichköpfelweg 9,**
**D-6101 Modautal 3 (DE)**

(74) Vertreter: **Riecke, Manfred, Neuköllner Strasse 8,**
**D-6333 Braunfels (DE)**

(54) **Tastenschalter und daraus aufgebaute Tastatur.**

(57) Die Erfindung betrifft die Ausbildung eines Tastenschalters sowie eine Tastatur, die aus derartigen Schaltern aufgebaut ist. Der Schalter besteht aus einem Dehnungsmeßstreifen (Oberseite) oder zwei Dehnungsmeßstreifen (Oberseite + Unterseite), welche auf der durchbiegbaren Zunge einer Platine oder dgl. angebracht sind. Eine aus derartigen Schaltern aufgebaute Tastatur besteht aus einer Platine oder aus Platinenelementen, in der bzw. in denen mehrere Zungen nebeneinander freigearbeitet sind. Jede Zunge ist mit mindestens einem Dehnungsmeßstreifen belegt. Es wird auch die Ausbildung eines derartigen Schalters als Folien-Schalter bzw. als Folien-Tastatur offenbart. Außerdem werden Auswerteschaltungen für das Signal des Dehnungsmeßstreifens beschrieben, die es ermöglichen, aus der bei Durchbiegung der Zunge geänderten analogen Größe im Dehnungsmeßstreifen ein eindeutiges digitales Schaltsignal zu gewinnen.

0175176

Die Erfindung betrifft einen Tastenschalter zur Erzeugung von elektrischen Signalen für die Steuerung von informationsverarbeitenden Geräten.

Tastenschalter der vorbezeichneten Art sind in den verschiedensten Ausführungsformen bekannt. Allgemein lassen sich die Tastenschalter in zwei Gruppen unterteilen, nämlich in solche, die mit mechanischen Kontakten arbeiten, und in solche, bei denen die Schaltung durch Beeinflussung anderer physikalischer Größen (elektrophysikalische Schalter) bewirkt wird. Hierunter ist zu verstehen, daß die Änderung des Magnetfeldes, des elektrischen Feldes oder des elektromagnetischen Feldes benutzt wird, um ein logisches Signal zu erzeugen. Diese Gruppe kommt daher ohne mechanische Kontakte aus.

All diese bekannten Schalter sind jedoch in der einen oder anderen Weise mit Nachteilen behaftet. Bei den mechanischen Schaltern liegt ein Hauptnachteil in der Korrosionsanfälligkeit der Kontakte. Ein anderer Nachteil liegt in dem Prelleffekt, der bei diesen Schaltern regelmäßig auftritt.

Die elektrophysikalischen Schalter, wie z.B. induktive und kapazitive Schalter, sind zwar von diesen Nachteilen frei, dafür sind sie aber meist relativ teuer und benötigen zur Ausgabe eines eindeutigen Signals oft eine aufwendige Auswerte-Elektronik.

0175176

Der Erfindung liegt die Aufgabe zugrunde, einen Schalter zu schaffen, der sowohl von den Nachteilen der mechanischen Schalter als auch von den Nachteilen der elektrophysikalisch arbeitenden Schalter weitestgehend frei ist, der durch seinen Aufbau eine sehr viel höhere Lebensdauer besitzt, der billig in der Herstellung ist, und der ferner in mehrfacher Aneinanderreihung als Tastatur eingesetzt werden kann.

Gemäß der Erfindung ist diese Aufgabe durch einen Tastenschalter gelöst, der die im Anspruch 1 angegebenen Merkmale aufweist. Weitere Merkmale des erfundenen Schalters sind in den Unteransprüchen aufgeführt.

Der erfundene Schalter besteht im Prinzip aus einem Dehnungsmeßstreifen, z.B. in einer Brückenschaltung, an deren Diagonalzweig ein Steuersignal ansteht, wenn die den Dehnungsmeßstreifen tragende Zunge einer Platine oder dgl. beim Tasten durchgebogen wird.

Dieser erfundene Schalter ist frei von allen Nachteilen der bisher bekannten Schalter und hat zudem den entscheidenden Vorteil, daß er sehr preisgünstig herstellbar ist, insbesondere dann, wenn mehrere Schalter dieser Art zu einer Tastatur vereinigt werden.

Vor allem besitzt der Schalter keine mechanisch bewegten Teile. Es treten daher weder ein Prelleffekt, noch Korrosion

- 3 -

0175176

oder mechanischer Verschleiß auf, welches die Lebensdauer stark erhöht. Ferner können der Schalter bzw. die Tastatur äußerst flach gehalten werden und sind daher für Folienbauweise besonders geeignet.

Ein weiterer ergonomischer Vorteil des Schalters liegt darin, daß nur ein minimaler Weg, eine minimale Durchbiegung der Zunge, erforderlich ist, um das Steuersignal zu erzeugen.

Für die konkrete Herstellung des Schalters wird vorgeschlagen, auf einer dünnen Platine eine Zunge frei zu legen, z.B. freizuschneiden oder freizufräsen, und auf dieser dann federnden Zunge den Dehnungsmeßstreifen aus einem Material mit hohem spezifischen Widerstandswert, und vor allem mit einem hohen K-Faktor, mittels eines an sich bekannten photochemischen Verfahrens aufzubringen. Unter K-Faktor ist dabei das Verhältnis von Dehnung zur erzielten Widerstandsänderung zu verstehen: $\frac{\Delta R}{R} = K \cdot \mathcal{E}$ , wobei " $\mathcal{E}$ " das Maß für die relative Dehnung ist.

Z.B. kann einseitig oder doppelseitig kaschiertes Basismaterial mit aufgepreßter oder aufgeklebter Konstantanfolie benutzt werden. Die Zungenfreimachung erfolgt dabei durch Stanzen oder auch durch Fräsen, wie bereits erwähnt.

Die Herstellung kann aber auch durch Spritzgießen erfolgen, wobei das Trägermaterial aus Polyetherimid unter Zugabe von Glasfasern bestehen kann. Die Zungenfreimachung,

- 4 -

0175176

die Tastenanschlußmöglichkeiten, das ganze Design usw. kann gleich beim Spritzgießverfahren mit erfolgen. Die Widerstandsschicht wird dann durch Bedampfen im Vakuum aufgebracht.

Es ist leicht verständlich, daß auf einer entsprechend groß bemessenen Platine mehrere Zungen in beliebiger Anordnung zueinander in nur einem Arbeitsgang gleichzeitig freigeschnitten oder gespritzt und anschließend in einem weiteren Arbeitsgang die Einzelwiderstände samt ihrer Verdrahtung auf photochemischem Wege erzeugt werden können, so daß man statt eines einzelnen Schalters eine ganze Tastatur erhält.

Ferner ist auch ein modularer Aufbau einer Tastatur mit steckbaren Spaltenelementen, d.h. mit in der Senkrechten des Tastenfeldes untereinander liegenden Tasten möglich. Dies bedeutet eine bahnbrechende Verbilligung in der Herstellung von Tastaturen.

Die Anordnung des Dehnungsmeßstreifens als variabler Widerstand in einer abgeglichenen Brückenschaltung mit zusätzlichen Festwiderständen erzeugt im Diagonalzweig der Meßbrücke keine Potentialdifferenz, solange der Dehnungsmeßstreifen (Taste) nicht durchgebogen ist. Bei Betätigung der Taste wird der elektrische Widerstand des Dehnungsmeßstreifens verändert, so daß im Diagonalzweig der Meß-

0175176

brücke eine Potentialdifferenz entsteht, die bei kleinen Auslenkungen dieser annähernd proportional ist. Da diese Potentialdifferenz dem Betrag nach sehr klein ist, muß sie zur weiteren Signalverarbeitung noch verstärkt werden. Zur digitalen Umformung des analogen Signals wird ein Schwellwertschalter verwendet, um eindeutige H oder L-Signale zu erhalten.

In der Zeichnung ist die Erfindung in mehreren Ausführungsbeispielen dargestellt. Es zeigen:

Fig. 1    schematisch die Anordnung eines Dehnungsmeßstreifens auf einer Zunge als Einzelwiderstand,

Fig. 2    schematisch die Ausbildung eines Tastenfeldes gemäß der Erfindung,

Fig. 3    schematisch den Aufbau einer Dehnungsmeßstreifen-Folientastatur,

Fig. 4    die Schaltung des Dehnungsmeßstreifens in einer Brücke,

Fig. 5    die Schaltung eines abgeglichenen Tastenfeldes mit zeilenweise getakteten Eingängen und verstärkten Spaltenausgängen,

Fig. 6    schematisch das Multiplexen eines Tastenfeldes mit Ansteuerung eines LED-Matrixfeldes.

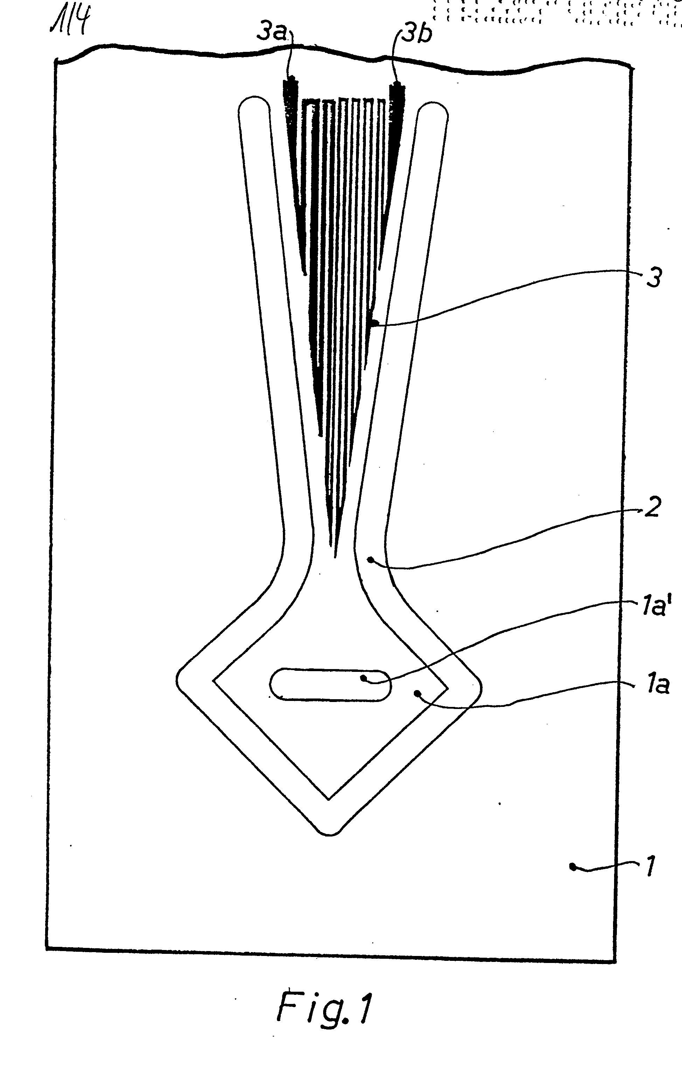

In Fig.1 ist mit 1 eine Platine bezeichnet, in der eine Zunge 1a freigeschnitten ist. Der Freischnitt besteht in einem Schlitz 2, der die Zunge an drei Seiten umschließt. An der vierten Seite ist die Zunge mit der Platine verbunden. Die Zunge 1a ist daher aus der Ebene der Platine herausbiegbar, d.h. durchbiegbar.

Wenn man der Zunge die in Fig.1 gezeigte dreiecksförmige Kontur gibt, erhält man einen Biegebalken konstanter Biegespannung, d.h. konstanter Dehnung der Widerstandsleiterbahnen.

Die Platine 1 besteht aus einem elektrisch nichtleitendem Werkstoff, z.B. aus Kunststoff, und ist nur wenige Millimeter dick. Auf der Zunge ist ein Dehnungsmeßstreifen 3 angebracht, z.B. aus einem aufgedampften Konstantanbelag herausgeätzt, in einer Schichtdicke im $\mu$-Bereich.

Im vorderen Teil der Zunge ist ein Langloch 1a' angebracht, in das ein Tastenknopf oder dgl. eingeknipst werden kann, der als Bedienungstaste des Schalters dient. Der nicht gezeigte Knopf kann unten mit einem verlängerten Bolzen, Abstandsstück oder dgl. versehen sein, der bei der Durchbiegung innen an einem Gehäuse oder dgl. anschlägt und daher den Biegeweg der Zunge begrenzt.

Mit 3a und 3b sind die Anschlüsse des Dehnungsmeßstreifens 3 bezeichnet, mittels derer der Dehnungsmeßstreifen in einen Stromkreis, d.h. an Spannung gelegt wird. Bei Druck auf die Zunge 1a ändert sich durch Längung bzw. Stauchung der Mäanderform des Dehnungsmeßstreifens dessen Widerstand, was zu einer Änderung des Spannungsabfalls am Dehnungsmeßstreifen im Stromkreis führt. Zur Erzielung eines eindeutigen Schaltzustandes wird jedoch vorgeschlagen, den Dehnungsmeßstreifen als variablen Widerstand in einer Brückenschaltung einzusetzen und die Brücke in der Weise abzugleichen, daß bei nichtbetätigtem Schalter, d.h. bei nichtdurchgebogener Zunge 1a die Brückendiagonalspannung gleich Null ist.

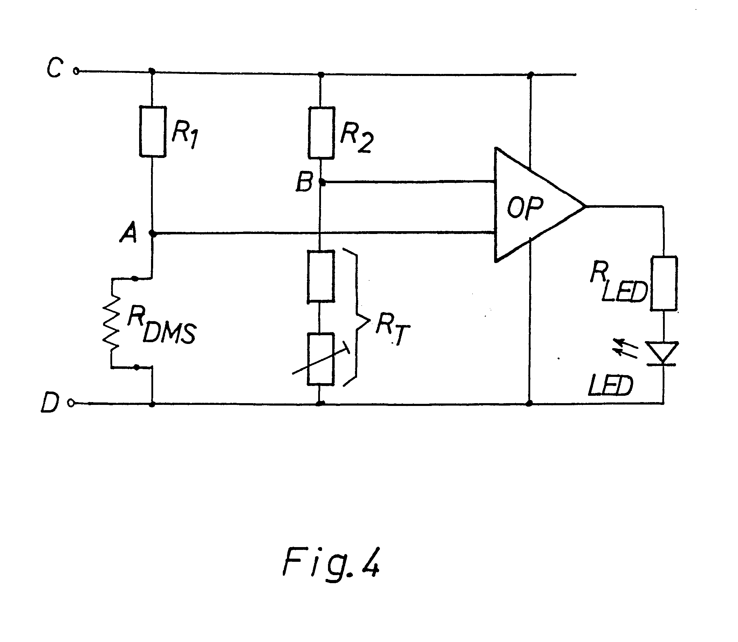

Eine derartige Schaltung ist in Fig.4 gezeigt. Neben zwei Festwiderständen $R_1$ und $R_2$ und einem Trimmwiderstand $R_T$ ist der Dehnungsmeßstreifen 3 als vierter variabler Widerstand $R_{DMS}$ in die Brücke geschaltet. In den Punkten A und B wird die Brückendiagonalspannung abgegriffen und zu einem als Schwellwertschalter arbeitenden Operationsverstärker OP geführt, an dessen Ausgang stets ein eindeutiges H oder L-Signal ansteht. In Fig.4 ist dies am Beispiel einer Leuchtdiode (LED) gezeigt, die eindeutig brennt oder nicht brennt.

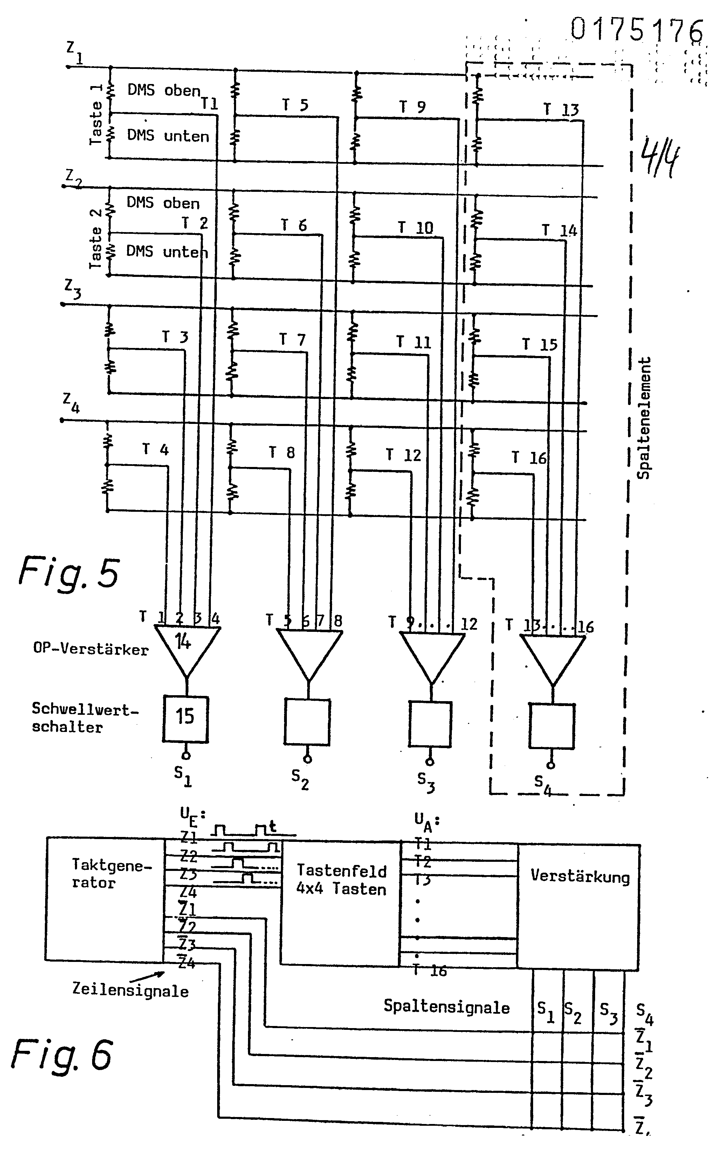

Zur Erhöhung der Diagonalspannung kann entweder die Speisespannung zwischen den Punkten CD angehoben werden oder man läßt weitere Widerstände an der Zungenbiegung teilnehmen, wenn sie wie $R_1$ im benachbarten Brückenzweig von $R_{DMS}$ liegen. Dies führt zu doppelseitig beschichteten Leiterplatten und zum Aufbau von Halbbrücken für jede Einzeltaste (Fig.5).

0175176

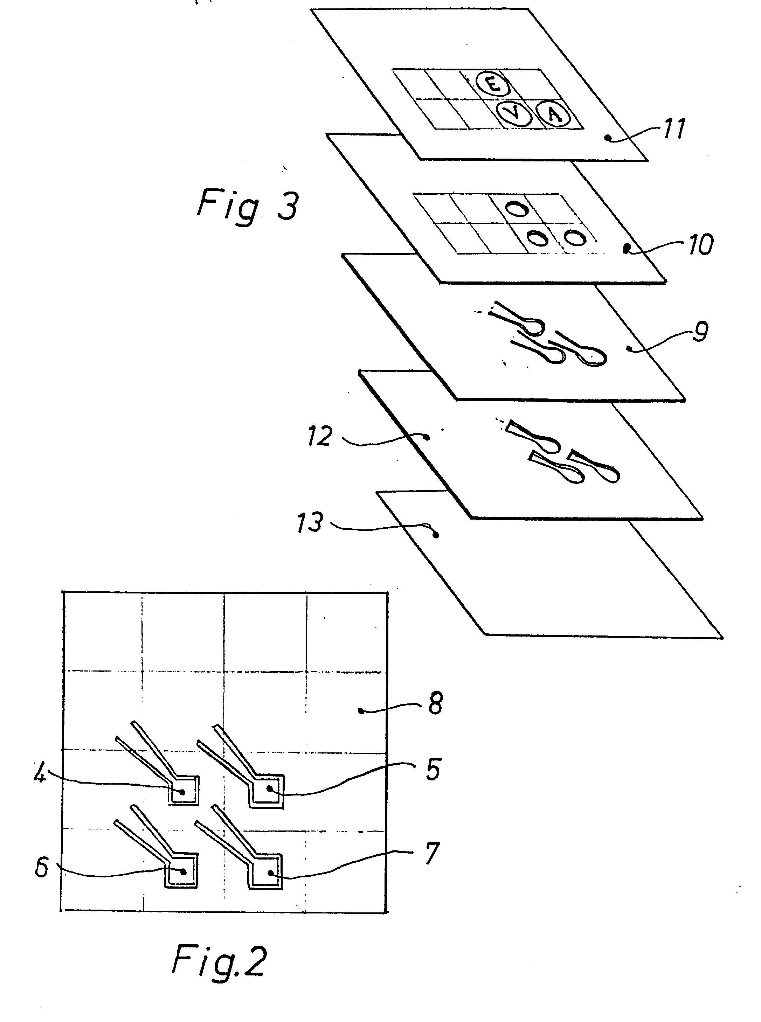

Fig.2 zeigt schematisch die Anordnung mehrerer Zungen 4-7 nebeneinander in einer Platine 8. Es ist leicht erkennbar, daß auf diese Weise in einfachster Art ein ganzes Tastenfeld hergestellt werden kann. Dabei ist auf jeder Zunge mindestens je ein Dehnungsmeßstreifen appliziert.

Auf Grund der geringen benötigten Durchbiegung der Zungen zur Erzielung eines verwertbaren Signales eignet sich der erfundene Tastenschalter besonders gut zum Aufbau einer Folientastatur. Dieser Aufbau ist schematisch in Fig.3 gezeigt. Die Platine mit den freigeschnittenen Zungen, auf denen die Dehnungsmeßstreifen angebracht sind, ist dort mit 9 bezeichnet.

Darüber ist eine Zentrierfolie 10 und hierüber wiederum eine obere Abdeckfolie 11 gelegt, welch letztere gleichzeitig die Zahlen oder Schriftzeichen der Tastatur trägt.

Unter die Platine 9 ist eine Hubbegrenzungsfolie 12 gelegt, in welcher der Raum der Zungen freigeschnitten ist. In diese freien Räume können jeweils die Zungen soweit eingedrückt werden, bis dieselben auf die noch darunter angeordnete untere Abdeckfolie 13 treffen. Die Dicke der Hubbegrenzungsfolie ist somit das Maß für die maximale Durchbiegung jeder Zunge.

Entlang ihrer Ränder können alle Folien verschweißt oder sonstwie hermetisch miteinander verbunden sein, so daß man eine völlig abgeschlossene Folientastatur erhält. Da alle Folien sehr dünn sein können und, wie bereits gesagt, nur eine geringe Durchbiegung der Zungen erforderlich ist, kann die Tastatur insgesamt sehr flach gehalten sein.

Fig.5 zeigt, wie beispielsweise ein abgeglichenes Tastenfeld (4x4 Matrix) aufgebaut und betrieben werden kann, wenn für die Ausgangssignale der Tasten $T_1$-$T_{16}$ die gegenläufige und sich daher verstärkende Wirkung der Widerstandsänderung von oben und unten liegendem Dehnungsmeßstreifen ausgenutzt wird.

Zur Kennung der Zeilensignale $Z_1$-$Z_4$ für die Halbbrückenspeisung wird zeilenweise gemultiplext, wobei die Zeilentakte von dem in Fig.6 dargestellten Taktgenerator erzeugt werden. Durch spaltenweises Zusammenschalten der Tastensignale auf je einen OP-Verstärker 14 liegen an dessen Ausgang nur Signale an, wenn wenigstens ein Element der Spalte gedrückt ist. Für logische Spaltensignale $S_1$-$S_4$ (TTL. CMOS) muß anschließend ein Schwellwertschalter 15 verwendet werden.

Die spaltenweise Signalverarbeitung kann zum modularen Aufbau einer Tastatur mittels steckbarer Spaltenelemente führen, die neben den Einzeltasten der Spalte und ihrer Verdrahtung bereits die Bausteine OP-Verstärker und Schwellwertschalter enthält. Symbolisch ist dies gestrichelt in Fig.5 angedeutet.

Mit den geschilderten Maßnahmen erreicht man eine weitere Kostensenkung durch Reduzierung der Elektronik-Bauteile.

Im Blockschaltbild der Fig.6 wird dann klar, daß nur dasjenige Element der LED-Matrix brennt bzw. entsprechende Schaltbefehle ausgeführt werden, deren Spalte und Zeile während der Betätigungszeit aktiviert sind. $\bar{Z}_1$ bis $\bar{Z}_4$ sind die invertierten Taktsignale der Zeilen, die in dem gezeigten Ausführungsbeispiel benötigt werden, bei dem angenommen ist, daß in den Schnittstellen der Matrix Leuchtdioden angesetzt sind. Sofern andere informationsverarbeitende Geräte angeschlossen werden, können die Taktsignale gegebenenfalls nichtinvertiert eingeführt werden.

0175176

Ansprüche

1.)     Tastenschalter zur Erzeugung von elektrischen Signalen für informationsverarbeitende Geräte, dadurch gekennzeichnet, daß als Schaltelement ein Dehnungsmeßstreifen (3) verwendet wird, der auf einer beim Tasten durchbiegbaren Zunge (1a) einer Platine (1) oder dgl. angeordnet ist.

2.)     Tastatur unter Verwendung eines Tastenschalters nach Anspruch 1, dadurch gekennzeichnet, daß an der Platine (8) mehrere Zungen (4-7) nebeneinander angeordnet sind, von denen jede mit mindestens einem Dehnungsmeßstreifen versehen ist.

3.)     Tastatur nach Anspruch 2, dadurch gekennzeichnet, daß die Platine spaltenweise modular aufgebaut ist.

4.)     Tastatur nach Anspruch 2, dadurch gekennzeichnet, daß die Platine (9), zusammen mit weiteren Folien (10-13), als Folientastatur ausgebildet ist.

5.)     Tastatur nach den Ansprüchen 2 und 3, <u>dadurch gekennzeichnet</u>, daß die Platine aus Kunststoff im Spritzgießverfahren hergestellt ist und an den einzelnen Zungen bzw. an den ihnen gegenüberstehenden Platineteilen Elemente zur Hubbegrenzung der Zungen mitangespritzt sind.

6.)     Tastenschalter nach Anspruch 1, <u>dadurch gekennzeichnet</u>, daß der Dehnungsmeßstreifen (3) als variabler Widerstand in einer Wheatstone'schen Viertel-, Halb- oder Vollbrücke untergebracht ist, in deren Diagonalzweig das Nutzsignal entsteht.

7.)     Tastenschalter nach Anspruch 6, <u>dadurch gekennzeichnet</u>, daß die Einzelwiderstände und deren Verschaltung mit einem gemeinsamen Herstellverfahren erzeugt werden.

8.)     Tastenschalter nach den Ansprüchen 1 und 6, <u>dadurch gekennzeichnet</u>, daß das analoge Nutzsignal nach einem Verstärker (OP) einem Schwellwertschalter (15) zugeführt wird, an dessen Ausgang je nach Schaltzustand ein eindeutiges Signal ansteht, so daß für die weitere digitale Signalverarbeitung TTL- oder CMOS-Bausteine verwendbar sind.

- 3 -

0175176

9.)     Tastenschalter nach den Ansprüchen 1 und 6-8, dadurch gekennzeichnet, daß die Zunge (1a; 4-7) beidseitig mit Dehnungsmeßstreifen (3) versehen ist, deren Verschaltung zu einer Wheatstone'schen Brücke erfolgt.

10.)     Tastatur nach den Ansprüchen 2 und 3, dadurch gekennzeichnet, daß das Tastenfeld über die Versorgungsspannung getaktete Zeileneingänge und verstärkte Spaltenausgänge zur weiteren logischen Signalverarbeitung besitzt (Multiplexverfahren).

114

3a  3b

3

2

1a'

1a

1

Fig.1

0175176

Fig 3

Fig.2

Fig. 4

**Fig. 5**

0175176

4/4

Z₁ — DMS oben / Taste 1 / DMS unten — T1 — T5 — T9 — T13
Z₂ — DMS oben / Taste 2 / DMS unten — T2 — T6 — T10 — T14
Z₃ — T3 — T7 — T11 — T15
Z₄ — T4 — T8 — T12 — T16

Spaltenelement

T 1 2 3 4 — 14 — OP-Verstärker
T 5 6 7 8
T 9 . . . 12
T 13 . . . 16

Schwellwert-schalter — 15

S₁   S₂   S₃   S₄

**Fig. 6**

U_E:
Z1, Z2, Z3, Z4
Z̄1, Z̄2, Z̄3, Z̄4

Taktgene-rator

Zeilensignale

Tastenfeld 4x4 Tasten

U_A:
T1, T2, T3 ... T 16

Verstärkung

Spaltensignale   S₁ S₂ S₃ S₄
Z̄₁
Z̄₂
Z̄₃
Z̄₄